(19) Europäisches Patentamt
European Patent Office
Office européen des brevets

(11) Veröffentlichungsnummer: **0 211 391**
**B1**

# (12) EUROPÄISCHE PATENTSCHRIFT

(45) Veröffentlichungstag der Patentschrift: **20.12.89**

(51) Int. Cl.[4]: **G03F 7/02**

(21) Anmeldenummer: **86110520.3**

(22) Anmeldetag: **30.07.86**

## (54) Lichtempfindliches Gemisch und damit hergestelltes lichtempfindliches Aufzeichnungsmaterial.

(30) Priorität: **07.08.85 DE 3528309**

(43) Veröffentlichungstag der Anmeldung:
**25.02.87 Patentblatt 87/9**

(45) Bekanntmachung des Hinweises auf die Patenterteilung:
**20.12.89 Patentblatt 89/51**

(84) Benannte Vertragsstaaten:
**BE CH DE FR GB IT LI NL SE**

(56) Entgegenhaltungen:
**EP-A- 0 126 875**
**EP-A- 0 152 819**
**DE-A- 2 406 400**
**FR-A- 2 020 258**
**FR-A- 2 234 583**
**US-A- 4 387 151**

(73) Patentinhaber: **HOECHST AKTIENGESELLSCHAFT, Postfach 80 03 20, D-6230 Frankfurt am Main 80(DE)**

(72) Erfinder: **Mack, Gerhard, Dr. Dipl.-Chem., Mainstrasse 32, D-6200 Wiesbaden(DE)**
Erfinder: **Pawlowski, Georg, Dr. Dipl.-Chem., Blücherstrasse 48, D-6200 Wiesbaden(DE)**

**EP 0 211 391 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein negativ arbeitendes lichtempfindliches Gemisch, das ein Diazoniumsalz-Kondensationsprodukt, eine polymerisierbare Verbindung, einen Photoinitiator und ein Bindemittel enthält, sowie ein damit hergestelltes Aufzeichnungsmaterial, das vorzugsweise für die Herstellung von Flachdruckplatten geeignet ist.

Kombinationen von photopolymerisierbaren Gemischen mit negativ arbeitenden Diazoverbindungen, besonders Diazoniumsalz-Polykondensationsprodukten, sind aus den DE-A 23 61 931, 29 03 270 und 30 07 212 (= GB-A 2 044 788) bekannt. Dabei wirkt entweder die Diazoverbindung selbst als Photoinitiator für die Polymerisation des Monomeren oder es wird ein zusätzlicher Photoinitiator zugesetzt. Als Vorteil wird vor allem die bessere Auflösung der Kopie gegenüber reinen photopolymerisierbaren Schichten und die erhöhte Druckauflage gegenüber Schichten angegeben, die allein Diazoverbindungen als lichtempfindliche Substanzen enthalten. Auch ist es in bestimmten Fällen möglich, die Entwicklung mit wäßrigen Lösungen oder sogar mit reinem Wasser durchzuführen.

Ein ähnliches Gemisch, das ein Bindemittel mit vernetzbaren seitenständigen Allylgruppen enthält, wird in der EP-A 104 863 beschrieben. Als Vorteil der hierin beschriebenen Gemische wird vor allem angegeben, daß die Lichtempfindlichkeit der damit hergestellten Aufzeichnungsmaterialien eine geringere Temperaturabhängigkeit aufweist. Als weiterer Vorteil wird die geringere Abhängigkeit der Lichtempfindlichkeit von dem zeitlichen Abstand zwischen Belichtung und Entwicklung angegeben. Offsetdruckplatten, die aus diesen lichtempfindlichen Gemischen hergestellt worden sind, haben jedoch den Nachteil einer verhältnismäßig geringen Auflagenstabilität und einer unerwünscht starken Tonwertzunahme während des Drucks.

Aus den Beispielen der Druckschrift ergibt sich, daß normalerweise auf die lichtempfindliche Schicht eine zusätzliche Sauerstoffsperrschicht aufgebracht wird. Das hat den Nachteil eines zusätzlichen Arbeitsschritts bei der Herstellung und der geringeren Bildauflösung in der Kopie. Daneben wird oft eine stärkere Tonwertzunahme infolge Unterstrahlung beobachtet. Ohne die Sauerstoffsperrschicht wird die Reziprozität der Schicht verschlechtert und zumeist die Lichtempfindlichkeit herabgesetzt; auch hat die lichtempfindliche Schicht selbst eine stärkere Klebrigkeit als die Sperrschicht.

In der nicht vorveröffentlichten EP-Patentanmeldung 85 108 159.6 (Prioritätstag: 10.7.1984, EP-A 167 963) wird ein lichtempfindliches Gemisch aus den oben genannten Bestandteilen beschrieben, das als Diazoniumsalz-Kondensationsprodukt ein Polykondensationsprodukt aus wiederkehrenden Einheiten A-$N_2X$ und B enthält, die durch Zwischenglieder, vorzugsweise Methylengruppen, miteinander verbunden sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

In der älteren, nicht vorveröffentlichten Europäischen Patentanmeldung 85 100 889.6 (Prioritätstag: 8.2.1984, EP-A 152 819) wird ein lichtempfindliches Gemisch, insbesondere für die Herstellung von Flachdruckplatten beschrieben, das ein Diazoniumsalz-Polykondensationsprodukt der vorstehend angegebenen Zusammensetzung und als Bindemittel ein Umsetzungsprodukt eines intramolekularen Anhydrids einer organischen Polycarbonsäure mit einem Hydroxylgruppen enthaltenden synthetischen Polymeren ist, das keine weiteren zur Umsetzung mit Säureanhydriden befähigten funktionellen Gruppen enthält.

Aufgabe der Erfindung war es, ein negativ arbeitendes lichtempfindliches Gemisch vorzuschlagen, das die Vorteile der bekannten Kombinationen aus photopolymerisierbaren Gemischen und Diazoniumsalz-Kondensationsprodukten aufweist, das Kopien mit hoher Auflösung und Flachdruckplatten mit geringer Tonwertzunahme und hoher Druckauflage ergibt, ohne daß eine Sauerstoffsperrschicht erforderlich ist.

Die Erfindung geht aus von einem lichtempfindlichen Gemisch, das als wesentliche Bestandteile

a) ein Diazoniumsalz-Polykondensationsprodukt,
b) eine radikalisch polymerisierbare Verbindung mit mindestens zwei endständigen ethylenisch ungesättigten Gruppen und einem Siedepunkt bei Normaldruck oberhalb 100°C,
c) einen unter Einwirkung von aktinischer Strahlung Radikale bildenden Polymerisationsinitiator und
d) ein in Wasser unlösliches, in organischen Lösungsmitteln und in wäßrig-alkalischen Lösungen lösliches polymeres Bindemittel

enthält.

Das erfindungsgemäße Gemisch ist dadurch gekennzeichnet, daß das Bindemittel ein Umsetzungsprodukt eines intramolekularen Anhydrids einer organischen Polycarbonsäure mit einem Hydroxylgruppen enthaltenden synthetischen Polymeren ist, das keine weiteren zur Umsetzung mit Säureanhydriden befähigten funktionellen Gruppen enthält.

Erfindungsgemäß wird ferner ein lichtempfindliches Aufzeichnungsmaterial, insbesondere für die Herstellung von Flachdruckplatten, mit einem Schichtträger und einer darauf aufgebrachten lichtempfindlichen Schicht vorgeschlagen, dessen lichtempfindliche Schicht aus einem Gemisch der vorstehend angegebenen Zusammensetzung besteht.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-C 20 24 244 beschrieben. Allgemein sind alle Diazoniumsalz-Polykondensationsprodukte geeignet, die in der DE-A 27 39 774 beschrieben sind.

Die Diazoniumsalzeinheiten $A\text{-}N_2X$ leiten sich bevorzugt von Verbindungen der Formel $(R^8\text{-}R^9\text{-})_pR^{10}\text{-}N_2X$ ab, wobei

X das Anion der Diazoniumverbindung,
p eine ganze Zahl von 1 bis 3,
$R^8$ einen aromatischen Rest mit mindestens einer zur Kondensation mit aktiver Carbonylverbindung befähigten Position,
$R^{10}$ eine Phenylengruppe,
$R^9$ eine Einfachbindung oder eine der Gruppen:
$-(CH_2)_q\text{-}NR^{11}$
$-O-(CH_2)_r\text{-}NR^{11}\text{-}$,
$-S-(CH_2)_r\text{-}NR^{11}\text{-}$,
$-S-CH_2CO\text{-}NR^{11}\text{-}$,
$-O\text{-}R^{12}\text{-}O\text{-}$,
- O -
- S -oder
$-CO\text{-}NR^{11}\text{-}$
bedeuten, worin
q eine Zahl von 0 bis 5,
r eine Zahl von 2 bis 5,
$R^{11}$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^{12}$ eine Arylengruppe mit 6 bis 12 C-Atomen ist.

Von den genannten Verbindungsklassen werden die Kondensationsprodukte der Diphenylamin-4-diazoniumsalze, die gegebenenfalls durch Alkyl-, Alkoxygruppen oder Halogenatome substituiert sind, bevorzugt. Als Zweitkomponenten B werden die gegebenenfalls substituierten Diphenylether, Diphenylsulfide, Diphenylmethane oder Diphenyle bevorzugt. Dabei werden für die Kondensation die Bis-methoxymethyl-, Bis-hydroxymethyl- oder Bis-acetoxymethylderivate der Grundkörper mit besonderem Vorteil eingesetzt. Das Kondensationsprodukt kann im Mittel 0,1 bis 50, bevorzugt 0,2 bis 20 Einheiten B je Einheit $A\text{-}N_2X$ enthalten.

Der Mengenanteil des Diazoniumsalz-Polykondensationsprodukts in dem Gemisch liegt im allgemeinen zwischen 5 und 60, vorzugsweise zwischen 10 und 40 Gew.-%, bezogen auf den Gesamtgehalt an nichtflüchtigen Bestandteilen.

Weitere besonders vorteilhafte Polykondensationsprodukte werden erhalten, indem ein ggf. substituiertes Diphenylamindiazoniumsalz zuerst mit einer aromatischen Verbindung $R'\text{-}O\text{-}CH_2\text{-}B$ und danach mit einer aromatischen Verbindung $R'\text{-}O\text{-}CH_2\text{-}B\text{-}CH_2\text{-}O\text{-}R'$ kondensiert wird, wobei R' ein Wasserstoffatom, ein Alkyl- oder aliphatischer Acylrest ist. Diese Kondensationsprodukte sind in der EP-A 126 875 beschrieben.

Als radikalisch polymerisierbare Verbindungen werden bevorzugt Acryl- oder Methacrylsäureester von mehrwertigen, insbesondere primären Alkoholen eingesetzt. Die Alkohole können 2 bis 6, bevorzugt 2 bis 4 OH-Gruppen enthalten. Es können auch kleinere Mengen (Meth)acrylester einwertiger Alkohole im Gemisch enthalten sein. Beispiele für geeignete Ester sind Trimethylolpropantriacrylat, Pentaerythrittri- und -tetraacrylat, Dipentaerythrithexamethacrylat, Propylenglykoldimethacrylat, Glycerindimethacrylat, Triethylenglykoldimethacrylat, Polyethylenglykoldiacrylat und Bisacrylate von oxyethylierten Bisphenol-A-Derivaten. Es sind auch die niedermolekularen, Urethangruppen enthaltenden Acrylate und Methacrylate geeignet, die durch Umsetzen von Hydroxyalkylacrylat oder -methacrylat mit zwei- oder mehrwertigen Isocyanaten erhalten werden. Die Isocyanate können wiederum durch Umsetzen von Diisocyanaten mit Diolen oder Triolen zu oligomeren Verbindungen erhalten worden sein. Die Menge an polymerisierbaren Verbindungen liegt im allgemeinen zwischen 10 und 65, bevorzugt bei 30 bis 60 Gew.-%.

Als Photoinitiatoren können eine Vielzahl von Verbindungen, gegebenenfalls auch Gemische von zwei oder mehreren verschiedenen, oftmals synergistisch wirkenden Verbindungen Verwendung finden. Beispiele sind Benzoin und seine Derivate, Mehrkernchinone, Acridinderivate, z. B. 9-Phenylacridin, 9-p-Methoxyphenyl-acridin, Benz(a)acridin; Phenazinderivate, z. B. 9,10-Dimethyl-benz(a)-phenazin, 10-Methoxy-benz(a)phenazin; Chinoxalinderivate, z. B. 6,4',4"-Trimethoxy-2,3-diphenyl-chinoxalin, 4,4"-Dimethoxy-2,3-diphenyl-5-azachinoxalin; aromatisch substituierte Bis-trichlormethyl-s-triazine oder trichlormethylsubstituierte Carbonylmethylenheterocyclen, z. B. 2-(p-Trichlormethyl-benzoylmethylen)-3-ethyl-benzthiazolin. Die Trichlormethylverbindungen werden besonders bevorzugt. Die Menge des Photoinitiators liegt im allgemeinen zwischen 0,05 und 10, bevorzugt zwischen 0,5 und 5 Gew.-%.

Die in dem erfindungsgemäßen Gemisch enthaltenen Bindemittel sind in der oben erwähnten nicht vorveröffentlichten EP-Anmeldung 85 108 159.6 beschrieben. Das zur Herstellung der Bindemittel eingesetzte Säureanhydrid leitet sich bevorzugt von einer Di- oder Tricarbonsäure, insbesondere einer Dicarbonsäure, ab und kann einen, zwei oder mehrere Ringe enthalten.

Besonders bevorzugte Bindemittel werden durch Umsetzen mit Säureanhydriden einer der Formeln I, II oder III

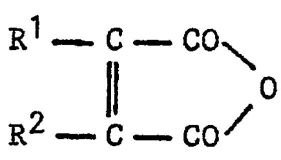 (I)

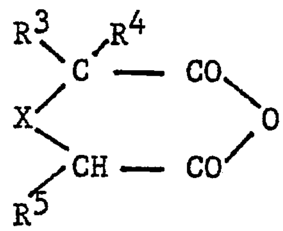 (II)

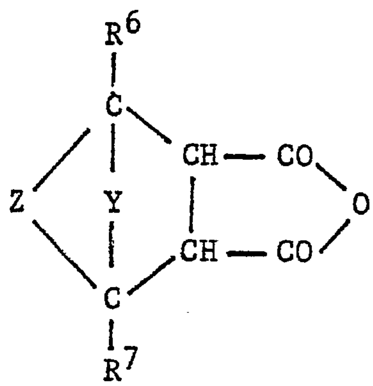 (III)

erhalten, worin

$R^1$ und $R_2$ einzeln Wasserstoffatome oder Alkylgruppen bedeuten oder miteinander zu einem aromatischen oder heteroaromatischen, gegebenenfalls substituierten und ggf. teilweise hydrierten 5- oder 6-gliedrigen Ring verbunden sind, an den bis zu zwei aromatische oder cycloaliphatische Ringe ankondensiert sein können,

$R^3$,$R^4$ und $R^5$ einzeln Wasserstoffatome oder Alkylgruppen bedeuten

oder

$R^3$ und $R^5$ miteinander zu einem ggf. substituierten gesättigten oder ungesättigten aliphatischen Ring verbunden sind, der einschließlich X fünf oder sechs Ringglieder haben kann,

$R^6$ und $R^7$ Wasserstoffatome oder Alkylgruppen,

X eine Einfachbindung, eine 1,1-Alkylengruppe, eine 1,1-Cycloalkylengruppe, die ggf. substituiert sind, ein Sauerstoff- oder Schwefelatom,

Y ein Sauerstoff- oder Schwefelatom, eine 1,1- oder 1,2-Alkylengruppe oder eine 1,2-Alkenylengruppe, an die ggf. ein aromatischer oder cycloaliphatischer Ring ankondensiert ist, und

Z die zur Vervollständigung eines gesättigten oder ungesättigten ggf. substituierten Rings erforderlichen Ringglieder bedeuten, wobei an diesen Ring bis zu zwei aromatische oder cycloaliphatische Ringe ankondensiert sein können.

Wenn $R^1$, $R^2$, $R^3$, $R^4$, $R^5$, $R^6$ oder $R^7$ Alkylgruppen bedeuten, haben diese im allgemeinen 1 bis 4, bevorzugt 1 bis 2 Kohlenstoffatome. Substituenten, die an die aromatischen oder cycloaliphatischen Ringe gebunden sein können, sind z.B. Alkylgruppen, Alkoxygruppen, Halogenatome, Nitrogruppen oder Carboxylgruppen.

Beispiele für geeignete Säureanhydride sind:

Maleinsäureanhydrid und Derivate,

z.B. Dimethylmaleinsäureanhydrid oder Citraconsäureanhydrid,

Bernsteinsäureanhydrid und Derivate,

z.B. Methylbernsteinsäureanhydrid,

Glutarsäureanhydrid und Derivate, z.B. 3-Methylglutarsäureanhydrid, 3,3-Tetramethylen-glutarsäureanhydrid oder Camphersäureanhydrid,
3-Oxa-glutarsäureanhydrid und Derivate, Phthalsäureanhydrid und Substitutionsprodukte,
z.B. Chlor-, Nitro- oder Carboxyphthalsäureanhydrid, teilweise oder vollständig hydrierte Phthalsäureanhydride, z.B. Hexahydrophthalsäureanhydrid oder Cyclohexen-1,2-dicarbonsäureanhydrid,
Naphthalin-2,3-dicarbonsäureanhydrid oder Naphthalin-1,8-dicarbonsäureanhydrid und deren Substitutionsprodukte,
Pyridin-o-dicarbonsäureanhydrid und dessen Substitutionsprodukte,
Pyrazin-o-dicarbonsäureanhydrid und dessen Substitutionsprodukte,
Furan-o-dicarbonsäureanhydrid oder Furan-2,5-dicarbonsäureanhydrid, deren Substitutionsprodukte sowie deren teilweise oder vollständig hydrierte Derivate,
Thiophen-o-dicarbonsäureanhydrid oder Thiophen-2,5-dicarbonsäureanhydrid, deren Substitutionsprodukte sowie deren ganz oder teilweise hydrierte Derivate,
di- oder polycyclische Anhydride, die durch Diels-Alder-Reaktion eines Diens mit Maleinsäureanhydrid entstehen, z.B. die Additionsprodukte aus Furan, Anthracen, Cyclohexadien-1,3 oder Cyclopentadien und Maleinsäureanhydrid.

Bevorzugt werden die Reaktionsprodukte mit Malein-, Phthal-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester- oder Vinylacetal- oder Vinylalkoholeinheiten geeignet.

Das Molekulargewicht der Carboxylgruppen enthaltenden Bindemittel kann innerhalb weiter Bereiche variieren. Im allgemeinen werden Bindemittel mit mittleren Molekulargewichten zwischen 5.000 und etwa 200.000 und darüber, vorzugsweise zwischen 10.000 und 100.000 eingesetzt. Die Säurezahl der Bindemittel kann im allgemeinen zwischen 5 und 80, bevorzugt zwischen 10 und 70 liegen. Der Mengenanteil an Bindemittel beträgt im allgemeinen 5 - 80, vorzugsweise 10 - 50 Gew.-%, bezogen auf die nichtflüchtigen Anteile des lichtempfindlichen Gemischs.

Die Umsetzung zwischen Säureanhydrid und Hydroxygruppen enthaltendem Polymeren kann in Ketonen, z.B. Butanon, oder Tetrahydrofuran, Dioxan oder anderen Ethern durchgeführt werden. Als Katalysatoren werden zweckmäßig tertiäre Amine eingesetzt. Im allgemeinen werden auf 100 Gewichtsteile Hydroxygruppen enthaltendes Polymeres 0,5 bis 20 Gewichtsteile Anhydrid, 1000 bis 3000 Gewichtsteile Lösungsmittel und 0,5 bis 5 Gewichtsteile tertiäres Amin verwendet.

Die erfindungsgemäßen Gemische können ferner Säuren, Inhibitoren für die thermische Polymerisation, Farbstoffe, Pigmente, Verlaufmittel, Weichmacher, Netzmittel und andere übliche Zusätze enthalten.

Die Gemische werden bevorzugt zur Herstellung lichtempfindlicher Druckplatten, insbesondere Flachdruckplatten, eingesetzt. In diesem Fall werden als Schichtträger vorwiegend Metalle, wie Zink, Stahl, verchromter Stahl, Messing/Chrom, Kupfer/Chrom oder Aluminium verwendet. Für Flachdruckplatten wird Aluminium bevorzugt, insbesondere mechanisch, chemisch oder elektrolytisch aufgerauhtes Aluminium, das bevorzugt noch mit einer anodisch erzeugten Oxidschicht versehen ist.

Die Gemische können auch in der Photoresisttechnik eingesetzt werden, z. B. zur Herstellung von Hoch-, Tief- oder Mehrmetalldruckplatten oder von gedruckten Schaltungen. Bei dieser Anwendung ist in vielen Fällen die erhöhte Auflösung gegenüber den sonst verwendeten photopolymerisierbaren Gemischen von besonderem Vorteil.

Bei allen Anwendungen kommen als Vorteile der erfindungsgemäßen Gemische gegenüber den bekannten Gemischen auf Basis Photopolymer/Diazoniumsalz-Kondensat eine erhöhte Lichtempfindlichkeit, erhöhte Lagerfähigkeit und verbesserte Haftung der lichtempfindlichen Schicht, insbesondere im belichteten Zustand, zur Geltung.

Als Lösemittel zur Bereitung der Beschichtungslösungen können je nach den Schichtbestandteilen z. B. Alkohole, wie Methanol und Ethanol; Glykolether wie Ethylenglykolmonoethylether; Dimethylformamid und Diethylformamid, Ether wie Dioxan, Tetrahydrofuran; Ester wie Essigsäureethylester, Butylacetat, Ethylenglykolmethyletheracetat; Ketone wie Methylethylketon, Cyclohexanon usw., verwendet werden.

Die lichtempfindliche Schicht kann in üblicher Weise durch Aufbringen der Lösung ihrer Bestandteile auf den Schichtträger erzeugt werden. Sie kann auch zunächst auf einen temporären Schichtträger aufgebracht werden, von dem sie mechanisch abtrennbar ist, und durch Laminieren auf den endgültigen Schichtträger, z. B. eine Nickelfolie oder die Kupferschicht eines Leiterplatten-Basismaterials übertragen werden.

Bei der Verarbeitung wird das Aufzeichnungsmaterial bildmäßig durch eine Vorlage belichtet. Zur Bildbelichtung kann jede in der Reproduktionstechnik gebräuchliche Lichtquelle dienen, die im langwelligen UV-Bereich emittiert, z. B. Kohlenbogenlampen, Quecksilberhochdrucklampen, Xenonimpulslampen und andere. Auch Elektronen- oder Laserstrahlung ist zur Bildaufzeichnung geeignet.

Nach der Belichtung wird mit einem geeigneten Entwickler entwickelt. Als Entwickler können z. B. wäßrige Netzmittellösungen, ggf. unter Zusatz von Alkali, deren Gemische mit organischen Lösemitteln, wäßrige Salzlösungen, wäßrige Lösungen von Säuren, z. B. von Phosphorsäuren, denen wiederum Salze oder organische Lösemittel zugesetzt werden können, oder wäßrig-alkalische Entwickler verwendet werden, z. B. wäßrige Lösungen von Natriumsalzen der Phosphorsäure oder der Kieselsäure. Auch diesen Entwicklern können organische Lösemittel zugesetzt werden. Es ist in manchen Fällen auch möglich, mit Wasser verdünnte organische Lösemittel zu verwenden. Die Entwickler können noch weitere Bestandteile, z. B. Netzmittel und Hydrophilierungsmittel, enthalten.

Die Entwicklung erfolgt in bekannter Weise, z. B. durch Tauchen und/oder Überwischen oder Besprühen mit der Entwicklerflüssigkeit. Dabei werden die nicht belichteten Schichtbereiche gelöst.

Die entwickelte Druckplatte kann noch zusätzlich durch Erwärmen auf eine Temperatur im Bereich von 150 - 230 °C nachgehärtet werden. Im allgemeinen reicht eine Zeit von 2 bis 20 Minuten für die Nachhärtung aus. Ein weiterer Vorteil ist die Möglichkeit zur Nachhärtung durch Belichten bzw. Bestrahlen der entwickelten Druckform. Diese Art der Nachbehandlung ist bei einer Druckplatte aus dem erfindungsgemäßen Gemisch wesentlich wirkungsvoller als bei einer Platte, deren lichtempfindliche Schicht nur aus einem photopolymerisierbaren Gemisch besteht. Eine derartige Platte wäre bei der Nachbelichtung ohne Vorlage und ohne sauerstoffhemmende Deckschicht, also in Gegenwart von Luftsauerstoff, nur mit sehr hohem Energieaufwand auszuhärten.

Die nachstehenden Beispiele beschreiben die Herstellung der erfindungsgemäßen lichtempfindlichen Gemische und der mit diesen hergestellten Aufzeichnungsmaterialien. In den Beispielen stehen Gewichtsteile (Gt.) und Volumenteile (Vt.) zueinander im Verhältnis von g zu ml. Prozentangaben sind, wenn nichts anderes angegeben ist, Gewichtsprozente, Temperaturen sind in °C angegeben.

Beispiel 1

Ein Aluminiumblech wurde elektrochemisch aufgerauht und anodisiert, anschließend zur Verbesserung der Hydrophilie mit einer wäßrigen Lösung von Polyvinylphosphonsäure behandelt. Darauf wurde die folgende Mischung in einer solchen Menge aufgetragen, daß ein Trockengewicht von 18 g/m² erreicht wurde:

1,5 Gt des Umsetzungsprodukts eines Polyvinylbutyrals mit einem Molekulargewicht von 70.000–80.000, das 71 Gew.-% Vinylbutyral-, 2 Gew.-% Vinylacetat- und 27 Gew.-% Vinylalkoholeinheiten enthält, mit Maleinsäureanhydrid (Säurezahl des Produkts 30),
0,45 Gt eines Diazoniumsalz-Polykondensationsprodukts aus 1 mol 3-Methoxy-diphenylamin-4-diazoniumsulfat und 1 mol 4,4'-Bis-methoxymethyl-diphenylether, ausgefällt als Mesitylensulfonat,
0,09 Gt Viktoriareinblau FGA (C.I. Basic Blue 81),
1,5 Gt Pentaerythrittetraacrylat/-triacrylat (technisches Gemisch),
0,12 Gt 2-(4-Styryl-phenyl)/4,6-bis-trichlormethyl-s-triazin und
0,04 Gt Phosphorsäure (85%) in
47,7 Gt 2-Methoxy/ethanol und
48,6 Gt Butanon.

Die erhaltene Druckplatte wurde unter einer Testvorlage belichtet und mit der folgenden Entwicklerlösung entwickelt.

0,2 Gt Natriummetasilikat × 9 $H_2O$,
3,9 Gt Dinatriumhydrogenphosphat × 12 $H_2O$,
3,5 Gt Trinatriumphosphat × 12 $H_2O$,
1,5 Gt Kaliumtetraborat × 4 $H_2O$ und
2,9 Gt Natriumoctylsulfat in
88,0 Gt entsalztem Wasser.

Mit der fertigen Druckform wurden in einer Offset-Druckmaschine 250.000 einwandfreie Drucke hergestellt. Die Druckform wies keine erkennbaren Schädigungen auf.

Beispiel 2

Trägermaterial und Schichtgewicht entsprachen Beispiel 1. Als Beschichtungslösung wurde verwendet:

1,5 Gt des Umsetzungsprodukts aus dem in Beispiel 1 angegebenen Polyvinylbutyral und Phthalsäureanhydrid (Säurezahl 45),
0,45 Gt des Diazoniumsalz-Kondensationsprodukts aus Beispiel 1,
0,09 Gt Viktoriareinblau FGA,
1,5 Gt des in Beispiel 1 angegebenen Pentaerythritesters,
0,12 Gt des in Beispiel 1 angegebenen Triazins und
0,04 Gt Phosphorsäure (85%) in
47,7 Gt 2-Methoxy-ethanol und
48,6 Gt Butanon.

Die bildmäßig belichtete Druckplatte wurde mit der Entwicklerlösung von Beispiel 1 entwickelt. Es wurde eine Druckauflage von 185.000 erhalten.

Beispiel 3

Mit einer Lösung von
1,5 Gt des in Beispiel 1 angegebenen polymeren Bindemittels,
0,88 Gt des Diazoniumsalz-Polykondensationsprodukts aus Beispiel 1,
0,09 Gt Viktoriareinblau FGA,
1,68 Gt des Pentaerythritesters aus Beispiel 1,
0,16 Gt des Triazins aus Beispiel 1 und
0,04 Gt Phosphorsäure (85%) in
47,65 Gt 2-Methoxy-ethanol und
48,0 Gt Butanon
wurde wie in Beispiel 1 beschrieben eine Druckplatte hergestellt. Die erzielte Druckauflage betrug 230.000.

Beispiel 4

Mit einer Lösung von
1,5 Gt des in Beispiel 1 angegebenen polymeren Bindemittels,
0,88 Gt eines Diazoniumsalz-Polykondensationsprodukts aus 3-Methoxy-diphenylamin-4-diazoniumsulfat und Formaldehyd,
0,09 Gt Viktoriareinblau FGA,
1,68 Gt des in Beispiel 1 angegebenen Pentaerythritesters,
0,16 Gt des in Beispiel 1 angegebenen Triazins und
0,04 Gt Phosphorsäure (85 %) in
74 Gt 2-Methoxy-ethanol und
21,6 Gt Butanon
wurde wie in Beispiel 1 beschrieben eine Druckplatte hergestellt. Die Druckauflage war 190.000.

Beispiel 5 (Vergleichsbeispiel)

Mit einer Lösung von
1,5 Gt eines Polymeren aus Styrol und Maleinsäuremonoallylester, (Molverhältnis 1:1, mittleres Molekulargewicht ca. 65.000),
0,45 Gt des Diazoniumsalz-Polykondensationsprodukts aus Beispiel 1,
0,09 Gt Viktoriareinblau FGA,
1,5 Gt des in Beispiel 1 angegebenen Pentaerythritesters,
0,12 Gt des Triazins aus Beispiel 1 und
0,04 Gt Phosphorsäure (85%) in
47,7 Gt 2-Methoxy-ethanol und
48,6 Gt Butanon
wurde wie in Beispiel 1 beschrieben eine Druckplatte hergestellt. Mit der fertigen Druckform wurde in einer Offset-Druckmaschine gedruckt. Ausbrüche von kleinen Rasterpunkten und Feinstrichelementen machten diese Druckform ab 145.000 Drucken unbrauchbar. Eine auf dem gleichen Druckmaschinenzylinder mitlaufende Druckplatte gemäß Beispiel 2 zeigte zu diesem Zeitpunkt noch keinerlei Schädigung.

Ein gleiches Ergebnis wurde beim vergleichenden Druckversuch mit der erfindungsgemäßen lichtempfindlichen Schicht von Beispiel 3 erhalten.

Beispiel 6 (Vergleichsbeispiel)

Man löst
1,5 Gt des Umsetzungsprodukts eines Octadecen-Maleinsäureanhydrid-Copolymeren mit Hydroxyethylmethacrylat,
0,45 Gt des Diazoniumsalz-Polykondensationsprodukts aus Beispiel 1,
0,09 Gt Viktoriareinblau FGA,
1,5 Gt des Pentaerythritesters aus Beispiel 1,
0,12 Gt des Triazins aus Beispiel 1 und
0,04 Gt Phosphorsäure (85%) in
47,7 Gt 2-Methoxy-ethanol und
48,6 Gt Butanon.

Die mit dieser Lösung entsprechend Beispiel 1 hergestellte Druckform zeigte ein ähnliches Verhalten wie die Druckform aus Beispiel 5 mit dem Styrol/Maleinsäurehalbester-Copolymeren als Bindemittel. Die Druckauflage betrug 125.000.

**Patentansprüche**

1. Lichtempfindliches Gemisch, das als wesentliche Bestandteile
a) ein Diazoniumsalz-Polykondensationsprodukt,
b) eine radikalisch polymerisierbare Verbindung mit mindestens zwei endständigen ethylenisch ungesättigten Gruppen und einem Siedepunkt bei Normaldruck oberhalb 100°C,
c) einen unter Einwirkung von aktinischer Strahlung Radikale bildenden Polymerisationsinitiator und
d) ein in Wasser unlösliches, in organischen Lösungsmitteln und in wäßrig-alkalischen Lösungen lösliches polymeres Bindemittel
enthält, dadurch gekennzeichnet, daß das Bindemittel ein Umsetzungsprodukt eines intramolekularen Anhydrids einer organischen Polycarbonsäure mit einem Hydroxylgruppen enthaltenden synthetischen Polymeren ist, das keine weiteren zur Umsetzung mit Säureanhydriden befähigten funktionellen Gruppen enthält.

2. Lichtempfindliches Gemisch nach Anspruch 1, dadurch gekennzeichnet, daß die organische Polycarbonsäure eine Di- oder Tricarbonsäure ist.

3. Lichtempfindliches Gemisch nach Anspruch 2, dadurch gekennzeichnet, daß das Säureanhydrid eine Verbindung einer der Formeln I, II und III

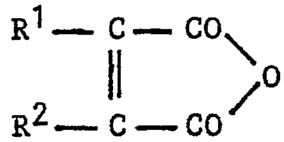 (I)

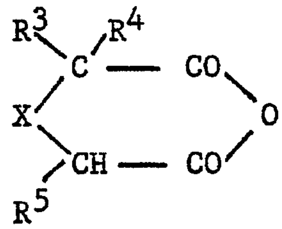 (II)

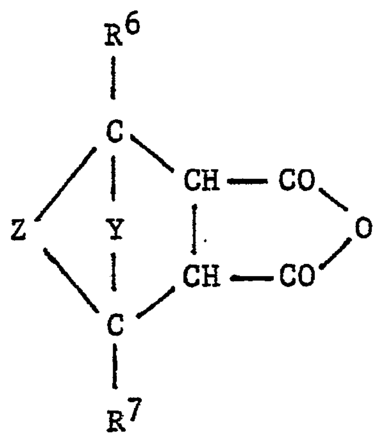 (III)

ist, worin
$R^1$ und $R^2$ einzeln Wasserstoffatome oder Alkylgruppen bedeuten oder miteinander zu einem aromatischen oder heteroaromatischen, gegebenenfalls substituierten und ggf. teilweise hydrierten 5- oder 6-gliedrigen Ring verbunden sind, an den bis zu zwei aromatische oder cycloaliphatische Ringe ankondensiert sein können,
$R^3$,$R^4$ und $R^5$ einzeln Wasserstoffatome oder Alkylgruppen bedeuten
oder
$R^3$ und $R^5$ miteinander zu einem ggf. substituierten gesättigten oder ungesättigten aliphatischen Ring verbunden sind, der einschließlich X fünf oder sechs Ringglieder haben kann,
$R^6$ und $R^7$ Wasserstoffatome oder Alkylgruppen,
X eine Einfachbindung, eine 1,1-Alkylengruppe, eine 1,1-Cycloalkylengruppe, die ggf. substituiert sind, ein Sauerstoff- oder Schwefelatom,
Y ein Sauerstoff- oder Schwefelatom, eine 1,1- oder 1,2-Alkylengruppe oder eine 1,2-Alkenylengruppe, an die ggf. ein aromatischer oder cycloaliphatischer Ring ankondensiert ist, und
Z die zur Vervollständigung eines gesättigten oder ungesättigten ggf. substituierten Rings erforderlichen Ringglieder bedeuten, wobei an diesen Ring bis zu zwei aromatische oder cycloaliphatische Ringe ankondensiert sein können.

4. Lichtempfindliches Gemisch nach Anspruch 3, dadurch gekennzeichnet, daß das Säureanhydrid Maleinsäureanhydrid, Phthalsäureanhydrid, Bernsteinsäureanhydrid oder 3-Oxaglutarsäureanhydrid ist.

5. Lichtempfindliches Gemisch nach Anspruch 1, dadurch gekennzeichnet, daß das Hydroxylgruppen enthaltende synthetische Polymere ein Polyvinylacetal oder ein Polyvinylacetat mit freien Hydroxylgruppen ist.

6. Lichtempfindliches Gemisch nach Anspruch 1, dadurch gekennzeichnet, daß das negativ arbeitende Diazoniumsalz-Polykondensationsprodukt aus wiederkehrenden Einheiten A-$N_2$X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

7. Lichtempfindliches Gemisch nach Anspruch 1, dadurch gekennzeichnet, daß die radikalisch polymerisierbare Verbindung ein Acryl- oder Methacrylsäureester eines mehrwertigen Alkohols ist.

8. Lichtempfindliches Gemisch nach Anspruch 1, dadurch gekennzeichnet, daß der Polymerisationsinitiator eine Verbindung mit mindestens einer photolytisch spaltbaren Trichlormethylgruppe ist.

9. Lichtempfindliches Gemisch nach Anspruch 1, dadurch gekennzeichnet, daß es 5 bis 60 Gew.-% Diazoniumsalz-Polykondensationsprodukt, 10 bis 65 Gew.-% radikalisch polymerisierbare Verbindung, 0,05 bis 10 Gew.-% Initiator und 5 bis 80 Gew.-% Bindemittel enthält.

10. Lichtempfindliches Aufzeichnungsmaterial mit einem Schichtträger und einer darauf aufgebrachten lichtempfindlichen Schicht, dadurch gekennzeichnet, daß die lichtempfindliche Schicht aus einem Gemisch gemäß Anspruch 1 besteht.

## Claims

1. A light-sensitive mixture which contains as essential constituents

a) a diazonium salt polycondensation product,

b) a free-radical polymerizable compound having at least two terminal ethylenically unsaturated groups and a boiling point under atmospheric pressure above 100°C,

c) a polymerization initiator which forms free radicals under the action of actinic radiation

and

d) a water-insoluble polymeric binder which is soluble in organic solvents and in aqueous-alkaline solutions,

characterized in that the binder is a reaction product of an intramolecular anhydride of an organic polycarboxylic acid with a hydroxyl-containing synthetic polymer which contains no further functional groups capable of reaction with acid anhydrides.

2. The light-sensitive mixture as claimed in claim 1, characterized in that the organic polycarboxylic acid is a dicarboxylic or tricarboxylic acid.

3. The light-sensitive mixture as claimed in claim 2, characterized in that the acid anhydride is a compound of one of the formulae I, II and III

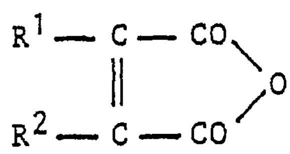 (I) 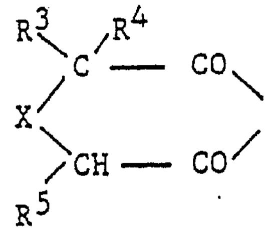 (II)

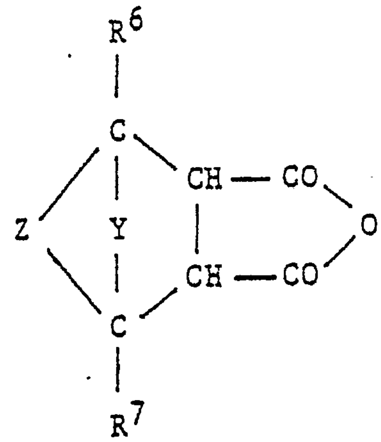 (III)

in which

$R^1$ and $R^2$ individually denote hydrogen atoms or alkyl groups or together are linked to form an aromatic or heteroaromatic, optionally substituted and optionally partially hydrogenated 5- or 6-membered ring onto which up to two aromatic or cycloaliphatic rings can be fused,

$R^3$, $R^4$ and $R^5$ individually denote hydrogen atoms or alkyl groups or

$R^3$ and $R^5$ together are linked to form an optionally substituted saturated or unsaturated aliphatic ring which, including X, can have five or six ring members,

$R^6$ and $R^7$ denote hydrogen atoms or alkyl groups,

X denotes a single bond, a 1,1-alkylene group or a 1,1-cycloalkylene group, which are optionally substituted, an oxygen or sulfur atom,

Y denotes an oxygen or sulfur atom, a 1,1-or 1,2-alkylene group or a 1,2-alkenylene group onto which an aromatic or cycloaliphatic ring may be fused, and

Z denotes the ring members required for completing a saturated or unsaturated optionally substituted ring, it being possible for up to two aromatic or cylcoaliphatic rings to be fused on to this ring.

4. The light-sensitive mixture as claimed 1, characterized in that the acid anhydride is maleic anhydride, phthalic anhydride, succinic anhydride or 3-oxaglutaric anhydride.

5. The light-sensitive mixture as claimed in claim 1, characterized in that the hydroxyl-containing synthetic polymer is a polyvinyl acetal or a polyvinyl acetate or a polyvinyl acetate having free hydroxyl groups.

6. The light-sensitive mixture as claimed in claim 1, characterized in that the negative working diazonium salt polycondensation product comprises repeating units A–$N_2$X and B which are bonded to one another through intermediate members, preferably methylene groups, which are derived from condensable carbonyl compounds, A being the radial of an aromatic diazonium compound which is condensable with is free of diazonium groups and condensable with formaldehyde, in particular of an aromatic amine, of a phenol, of a phenol ether, of an aromatic thioether, of an aromatic hydrocarbon, of an aromatic heterocyclic compound or of an organic acid amide.

7. The light-sensitive mixture as claimed in claim 1, characterized in that the free-radical polymerizable compound is an acrylic or methacrylic acid ester of a polyhydric alcohol.

8. The light-sensitive mixture as claimed in claim 1, characterized in that the polymerization initiator is a compound having at least one photolytically cleavable trichloromethyl group.

9. The light-sensitive mixture as claimed in claim 1, characterized in that it contains 5 to 60% by weight of diazonium salt polycondensation product, 10 to 65% by weight of free-radical-polymerizable compound, 0.05 to 10% by weight of initiator and 5 to 80% by weight of binder.

10. A light-sensitive recording material comprising a support material and, applied thereto, a light-sensitive layer, characterized in that the light-sensitive layer is composed of a mixture as claimed in claim 1.

## Revendications

1. Mélange photosensible renfermant les constituants essentiels suivants:
a) un produit de polycondensation de sel de diazonium,
b) un composé polymérisable par un mécanisme radicalaire, à au moins deux groupes terminaux à insaturation éthylénique et un point d'ébullition à pression normale supérieur à 100°C,
c) un initiateur de polymérisation générateur de radicaux libres sous l'effet de la lumière actinique et
d) un liant polymère insoluble dans l'eau et soluble dans des solvants organiques et dans des solutions hydroalcalines,
caractérisé en ce que le liant est un produit de réaction d'un anhydride intramoléculaire d'un acide polycarboxylique organique avec un polymére synthétique renfermant des groupes hydroxyle et qui ne contient pas d'autres groupes fonctionnels susceptibles de réagir avec des anhydrides d'acide,

2. Mélange photosensible selon la revendication 1, caractérisé en ce que l'acide polycarboxylique est un acide di- ou tricarboxylique.

3. Mélange photosensible selon la revendication 2, caractérisé en ce que l'anhydride d'acide est un composé de l'une des formules I, II ou III

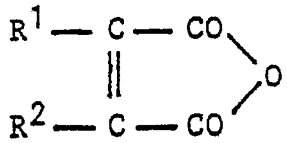 (I)

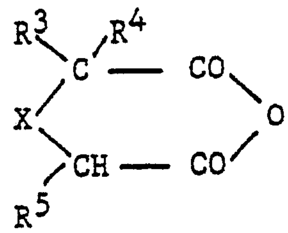 (II)

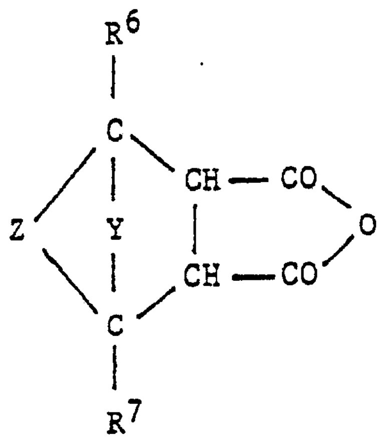 (III)

dans lesquelles
$R^1$ et $R^2$ sont des atomes d'hydrogéne ou des groupes alkyle, ou bien forment ensemble un cycle penta- ou hexagonal aromatique ou hétéroaromatique éventuellement substitué et éventuellement partiellement hydrogéné, auquel peuvent être condensés jusqu'à deux cycles aromatiques ou cycloaliphatiques,
$R^3$, $R^4$ et $R^5$ sont des atomes d'hydrogène ou des groupes alkyle, ou
$R^3$ et $R^5$ ensemble peuvent constituer un cycle aliphatique saturé ou insaturé éventuellement substitué, qui, avec X, peut être penta- ou hexagonal,
$R^6$ et $R^7$ sont des atomes d'hydrogène ou des groupes alkyle,
X est une liaison simple, un groupe 1,1-alkylène, un groupe 1,1-cycloalkylène, éventuellement substitués, un atome d'oxygène ou de soufre,
Y est un atome d'oxygène ou de soufre, un groupe 1,1-alkylène ou un groupe 1,2-alkylène ou un groupe 1,2-alkénylène, auquel est éventuellement condensé un cycle aromatique ou cycloaliphatique, et
Z représente les maillons nécessaires pour compléter un cycle saturé ou insaturé éventuellement substitué, auquel jusqu'à deux cycles aromatiques ou cycloaliphatiques peuvent être condensés.

4. Mélange photosensible selon la revendication 3, caractérisé en ce que l'anhydride d'acide est l'anhydride maléique, l'anhydride phtalique, l'anhydride succinique ou l'anhydride 3-oxoglutarique.

5. Mélange photosensible selon la revendication 1, caractérisé en ce que le polymère synthétique contenant des groupes hydroxyle est un polyvinylacétal ou un poly(acétate de vinyle) à groupes hydroxyle libres.

6. Mélange photosensible selon la revendication 1, caractérisé en ce que le produit de polycondensation de sel de diazonium travaillant en négatif est constitué d'unités répétitives A–$N_2X$ et B, qui sont liées entre elles par des groupes intermédiaires, de préférence des groupes méthylène, dérivés de composés carbonyliques condensables, A étant le reste d'un composé diazoïque aromatique condensable avec le formaldéhyde et B le reste d'un composé condensable avec le formaldéhyde et exempt de groupes diazoïques, en particulier d'une amine aromatique, d'un phénol, d'un éther de phénol, d'un thioéther aromatique, d'un hydrocarbure aromatique, d'un composé hétérocyclique aromatique ou d'un amide d'acide organique.

7. Mélange photosensible selon la revendication 1, caractérisé en ce que le composé polymérisable par des radicaux libres est un ester acrylique ou méthacrylique d'un polyol.

8. Mélange photosensible selon la revendioation 1, caractérisé en ce que l'initiateur de polymérisation est un composé ayant au moins un groupe trichlorométhyle photolytiquement scindable.

9. Mélange photosensible selon la revendication 1, caractérisé en ce qu'il contient de 5 à 60% en poids de produit de polycondensation de sel de diazonium, 10 à 65% en poids de composé polymérisable par des radicaux libres, de 0,05 à 10% en poids d'initiateur et de 5 à 80% en poids de liant.

10. Matériel d'enregistrement photosensible avec un support de couche et une couche photosensible déposée sur ledit support, caractérisé en ce que la couche photosensible est constituée d'un mélange selon la revendication 1.